(19) **Europäisches Patentamt / European Patent Office / Office européen des brevets**

(11) **EP 4 421 513 A1**

(12) # EUROPÄISCHE PATENTANMELDUNG

(43) Veröffentlichungstag:
**28.08.2024 Patentblatt 2024/35**

(21) Anmeldenummer: 23158173.7

(22) Anmeldetag: **23.02.2023**

(51) Internationale Patentklassifikation (IPC):
**G01R 33/56** (2006.01)  **G06N 3/02** (2006.01)

(52) Gemeinsame Patentklassifikation (CPC):
**G01R 33/5608;** G06N 3/0464; G06N 3/09

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: **Siemens Healthineers AG
91301 Forchheim (DE)**

(72) Erfinder:
• **Zeller, Mario
91054 Erlangen (DE)**
• **Krug, Andreas
90762 Fürth (DE)**

(74) Vertreter: **Siemens Healthineers
Patent Attorneys
Postfach 22 16 34
80506 München (DE)**

(54) **COMPUTERIMPLEMENTIERTES VERFAHREN ZUM BETRIEB EINER MAGNETRESONANZEINRICHTUNG, COMPUTERPROGRAMM, ELEKTRONISCH LESBARER DATENTRÄGER UND RECHENEINRICHTUNG**

(57)    Die Erfindung betrifft ein Computerimplementiertes Verfahren zum Betrieb einer Magnetresonanzeinrichtung (52), wobei zur Ermittlung wenigstens einer potentiellen Ursache für einen Fehlwert, insbesondere einen Spike-Fehlwert, in den Bilddaten wenigstens eines Bildgebungsvorgangs
- ein zu analysierender Eingangsdatensatz umfassend während dem Bildgebungsvorgang erfasste Hochfrequenzsignaldaten zusammengestellt wird,
- auf den Eingangsdatensatz eine trainierte Klassifizierungsfunktion (38) der künstlichen Intelligenz zur Ermittlung eines Ausgangsdatensatzes (43), der potentielle Ursachen des Fehlwerts beschreibt, angewendet wird, und
- wenigstens ein Teil der Ausgangsdaten des Ausgangsdatensatzes (43) ausgegeben wird.

FIG 3

EP 4 421 513 A1

**Beschreibung**

Unabhängig vom grammatikalischen Geschlecht eines bestimmten Begriffes sind Personen mit männlicher, weiblicher oder anderer Geschlechteridentität mit umfasst.

Die Erfindung betrifft ein computerimplementiertes Verfahren zum Betrieb einer Magnetresonanzeinrichtung, wobei wenigstens eine potentielle Ursache für einen Fehlwert, insbesondere einen Spike-Fehlwert, in den Bilddaten wenigstens eines Bildgebungsvorgangs ermittelt wird. Daneben betrifft die Erfindung ein Computerprogramm, einen elektronisch lesbaren Datenträger und eine Recheneinrichtung, insbesondere eine Steuereinrichtung einer Magnetresonanzeinrichtung.

Die Magnetresonanzbildgebung ist eine insbesondere im medizinischen Bereich etablierte Bildgebungsmodalität, die hochgenaue Einblicke in zu untersuchende Objekte, insbesondere den menschlichen Körper, gewährt. Mittels eines Hauptmagneten einer in einer Schirmkabine positionierten Hauptmagneteinheit einer Magnetresonanzeinrichtung wird ein Hauptmagnetfeld (B0-Feld) erzeugt, wobei unter Nutzung wenigstens einer Hochfrequenzspulenanordnung durch Anregungspulse Kernspins in zu untersuchenden Objekt angeregt werden können. Der Zerfall dieser Anregungen wird als Magnetresonanzsignale vermessen. Zur Ortskodierung werden durch eine Gradientenspulenanordnung erzeugte Gradientenfelder eingesetzt. Die Magnetresonanzdaten werden dabei üblicherweise im sogenannten k-Raum gemessen und in den Bildraum transformiert.

Auch die Magnetresonanzbildgebung ist durch verschiedene Ursachen Fehlmessungen, also fehlerhaften Werten (Fehlwerten) in während eines Bildgebungsvorgangs aufgenommenen Bilddaten, unterworfen. Speziell sind in diesem Zusammenhang sogenannte Spike-Fehlwerte zu nennen, also fehlerhaft mit zu hoher Intensität gemessene Signale im k-Raum. Mithin können Spike-Fehlwerte als k-Raumwerte, also Messwerte der Bilddaten, verstanden werden, welche keine reale Eigenschaft eines untersuchten Objekts beschreiben und insbesondere Peaks/Intensitätsspitzen sind. Solche Fehlwerte können verschiedene Artefakte beziehungsweise allgemein Effekte im rekonstruierten Magnetresonanzdatensatz, insbesondere rekonstruierten Bild, hervorrufen, beispielsweise ein reduziertes Signal-zu-Rauschverhältnis, Shading oder sonstige Bildartefakte. Beispielhafte Ursachen für Spike-Fehlwerte umfassen Überspannungen, vibrierende mechanische Teile, Fremdkörper wie beispielsweise Münzen in der Patientenaufnahme oder externe Hochfrequenz-Störeffekte. Externe Hochfrequenz-Störeffekte können beispielsweise durch Netzteile in der Schirmkabine, defekte Leuchtstoffröhren und/oder Einflüsse von außerhalb durch eine nicht korrekt geschlossene Tür zur Schirmkabine entstehen.

In einem konkreten Beispiel können Spike-Fehlwerte, die die normale Bildrekonstruktion wie Filterung, Fouriertransformation sowie weitere Vorgänge, beispielsweise Rekonstruktionsalgorithmen der parallelen Bildgebung, durchlaufen und von vibrierenden Teilen in der Patientenliege hervorgerufen werden, starke diagonale Streifen im Bildergebnis verursachen, die im Falle einer Überlagerung von relevanten Bildinformationen zu deren schlechterer Erkennbarkeit und/oder zu einer Fehlbewertung als relevante Bildinformation führen können.

Im Stand der Technik wurden bereits verschiedene Vorgehensweisen zur Detektion und zur Behebung von Spike-Fehlwerten vorgeschlagen. Dabei existieren insbesondere Hardwarebasierte Filter und Software-basierte Ansätze.

DE 10 2018 216 362 B3 offenbart ein Verfahren und ein System zum Bereinigen eines Magnetresonanz-Messdatensatzes. Dabei wird ein Messdatensatz aus k-Raumwerten erfasst, wonach ein oder mehrere GRAPPA-Kerne für den oder auf den Messdatensatz kalibriert werden. Die k-Raumwerte des Messdatensatzes werden dann anhand eines vorgegebenen Intensitätskriteriums überprüft, um Fehlwerte aufzufinden. Sodann erfolgt eine punktweise Rekonstruktion von k-Raumwerten des Messdatensatzes mittels der kalibrierten GRAPPA-Kerne durch eine jeweilige Linearkombination von jeweils anderen k-Raumwerten, welche nach einem vorgegebenen Schema ausgewählt werden. Zum Erzeugen eines bereinigten Messdatensatzes werden die Fehlwerte durch die entsprechenden rekonstruierten k-Raumwerte ersetzt. Im Intensitätskriterium kann beispielsweise ein Überschreiten eines vorgegebenen Schwellenwertes überprüft werden.

US 10 705 170 B1 betrifft Verfahren und Systeme zur Entfernung von Spike-Rauschen in der Magnetresonanzbildgebung. Dabei wird vorgeschlagen, ein trainiertes Deep-Learning-Netzwerk einzusetzen, um Spike-Rauschen zu identifizieren und zu korrigieren, insbesondere zu reduzieren beziehungsweise zu entfernen. Insbesondere soll es dabei möglich sein, Spikes nahe des k-Raum-Zentrums von starken, korrekten Magnetresonanzsignalen zu unterscheiden.

Wie bereits erläutert wurde, können die Ursachen für Spike-Fehlwerte unterschiedliche Ursachen haben, deren Beseitigung unterschiedlich komplex ist (Türschließen, Leuchtstoffröhre tauschen, Münzen wegsammeln, Gradientenspule tauschen und dergleichen). Erfolgt eine Störungsmeldung, wird üblicherweise ein Techniker zur Magnetresonanzeinrichtung geschickt, um die Ursache aufzufinden. Dies ist sowohl hinsichtlich der Kosten als auch hinsichtlich des sonstigen Aufwands nachteilhaft. Ferner besteht das Risiko, dass die tatsächliche Ursache übersehen wird.

Der Erfindung liegt daher die Aufgabe zugrunde, eine leichtere Störungsbeseitigung beim Auftreten von Spike-Fehlwerten in Bilddaten bei Bildgebungsvorgängen anzugeben.

Diese Aufgabe wird erfindungsgemäß gelöst durch ein computerimplementiertes Verfahren, ein Computerprogramm, einen elektronisch lesbaren Datenträger und eine Recheneinrichtung gemäß den unabhängigen Patentansprüchen. Vorteilhafte Ausgestaltungen ergeben sich aus den Unteransprüchen.

Ein erfindungsgemäßes computerimplementiertes Verfahren zum Betrieb einer Magnetresonanzeinrichtung umfasst zur Ermittlung wenigstens einer potentiellen Ursache für einen Fehlwert, insbesondere ein Spike-Fehlwert, in den Bilddaten wenigstens eines Bildgebungsvorgangs folgende Schritte:

- Zusammenstellen eines zu analysierenden Eingangsdatensatzes umfassend während dem Bildgebungsvorgang erfasste Hochfrequenzsignaldaten,
- Anwenden einer trainierten Klassifizierungsfunktion der künstlichen Intelligenz auf den Eingangsdatensatz zur Ermittlung eines Ausgangsdatensatzes, der potentielle Ursachen des Fehlwerts beschreibt, und
- Ausgabe wenigstens eines Teils der Ausgangsdaten des Ausgangsdatensatzes.

Erfindungsgemäß wurde erkannt, dass sich die Ursachen für Spike-Fehlwerte oftmals einem bestimmten Muster in Hochfrequenzsignaldaten (sowie gegebenenfalls weiterer Daten) zuordnen lassen, wobei die Hochfrequenzsignaldaten mit besonderem Vorteil wenigstens einen Teil der Bilddaten des Bildgebungsvorgangs im k-Raum und/oder in einem Hybridraum und/oder im Bildraum umfassen können. Beispielsweise wurde festgestellt, dass Spike-Fehlwerte durch defekte Leuchtstoffröhren an einer Vielzahl von Positionen in ky-Richtung auftreten, aber jeweils an der gleichen kx-Position im k-Raum. Locker sitzende Gradientenkabel der Gradientenspulen verursachen Spike-Fehlwerte in der Regel am Beginn oder am Ende des k-Raums in kx-Richtung, sind aber in ky-Richtung zufälliger verteilt. Metallteile in der insbesondere zylindrischen Patientenaufnahme einer Hauptmagneteinheit der Magnetresonanzeinrichtung führen zu komplett zufälligen Verteilungen. Weitere Unterschiede der verschiedenen Ursachen können sich beispielsweise daraus ergeben, ob die Spike-Fehlwerte in Abhängigkeit von hohen Strömen oder Spannungen auftreten. Aufgrund dieser Erkenntnis wird vorgeschlagen, einen trainierten Klassifizierungsalgorithmus der künstlichen Intelligenz, insbesondere umfassend ein neuronales Netz, zur Klassifikation der Fehlwert-Ursache anhand von aufgenommenen Eingangsdaten des Bildgebungsvorgangs, die wenigstens Hochfrequenzsignaldaten umfassen, einzusetzen.

Im Allgemeinen bildet eine trainierte Funktion, also auch die trainierte Klassifizierungsfunktion, kognitive Funktionen ab, die Menschen mit anderen menschlichen Gehirnen assoziieren. Durch Training basierend auf Trainingsdaten (Maschinenlernen) ist die trainierte Funktion in der Lage, sich an neue Umstände anzupassen und Muster zu detektieren und zu extrapolieren.

Allgemein gesagt können Parameter einer trainierten Funktion durch Training angepasst werden. Insbesondere können überwachtes Lernen, halbüberwachtes Lernen, nicht überwachtes Lernen, reinforcement learning und/oder aktives Lernen verwendet werden. Darüber hinaus kann auch Repräsentationslernen (auch als "feature learning" bekannt) eingesetzt werden. Die Parameter der trainierten Funktion können insbesondere iterativ durch mehrere Trainingsschritte angepasst werden.

Eine trainierte Funktion kann beispielsweise ein neuronales Netz, eine Support Vector Machine (SVM), einen Entscheidungsbaum und/oder ein Bayes-Netzwerk umfassen und/oder die trainierte Funktion kann auf k-Means-Clustering, Q-Lernen, genetischen Algorithmen und/oder Zuordnungsregeln basieren. Insbesondere kann ein neuronales Netzwerk ein tiefes neuronales Netzwerk, ein Convolutional Neural Network (CNN) oder ein tiefes CNN sein. Darüber hinaus kann das neuronale Netzwerk ein Adversarial Network, ein tiefes Adversarial Network und/oder ein Generative Adversarial Network (GAN) sein.

Die trainierte Klassifizierungsfunktion kann auch zur Detektion des Vorliegens wenigstens eines Fehlwerts und zur Ausgabe eines das Vorliegen keines Fehlwerts anzeigenden Ausgangsdatensatzes bei Feststellen keines Fehlwerts ausgebildet sein. Alternativ kann das Vorliegen eines Fehlwerts anderweitig, insbesondere durch eine entsprechende, gegebenenfalls ebenso trainierte, Detektionsfunktion, im Vorfeld erfolgen, wobei dann die trainierte Klassifizierungsfunktion nur bei positivem Ergebnis der Detektionsfunktion zur weiteren Analyse eingesetzt wird.

Fehlwerte, insbesondere Spike-Fehlwerte, im Sinne der Erfindung sind k-Raumwerte, also Messwerte der Bilddaten, welche tatsächlich oder vermutlich durch Störungen erzeugt, verändert oder beeinflusst wurden und daher keine tatsächliche Eigenschaft eines jeweiligen untersuchten Objekts angeben oder beschreiben. Fehlwerte können daher als Kontaminationen des die Bilddaten enthaltenden Messdatensatzes verstanden werden. Insbesondere kann es sich bei den Fehlwerten, insbesondere Spike-Fehlwerten, um Peaks und/oder Intensitätsspitzen handeln, mithin Signalüberhöhungen im k-Raum, welche bei einer Rekonstruktion eines Magnetresonanzbildes, beziehungsweise allgemein Magnetresonanzdatensatzes, aus den k-Raumwerten zu Bildstörungen und/oder Artefakten führen und/oder beitragen können.

Werden, was bevorzugt ist, Bilddaten des wenigstens einen Bildgebungsvorgangs als Hochfrequenzsignaldaten verwendet, können diese beispielsweise in Form einer mit den k-Raumwerten gefüllten Matrix vorliegen. Die Zeilen einer solchen Matrix liegen hierbei häufig in der kx-Richtung und können als k-Raumzeilen verstanden werden. Die k-Raum-Darstellung der Bilddaten bietet den Vorteil, dass Spike-Fehlwerte in der Regel als klar abgrenzbare Punkte vorliegen. Jedoch kann für eine Klassifizierung auch eine Bildraumdarstellung der Bilddaten oder eine Hybridraumdarstellung, in der beispielsweise eine Fourier-Transformation nur teilweise vorgenommen wurde, zweckmäßig sein. Einzelne Punkte im k-Raum führen zu Wellenmustern im Bildraum, welche von auf Mustererkennung trainierten Architekturen der trainierten Klassifizierungsfunktion besonders gut erkannt werden können, insbesondere, wenn die Spike-Fehlwerte nahe am signalreichen k-Raumzentrum liegen.

In einem ersten Schritt des erfindungsgemäßen Verfahrens wird ein Eingangsdatensatz mit Eingangsdaten für den trainierten Klassifizierungsalgorithmus zusammengestellt. Grundlage für diese Zusammenstellung können über eine erste Schnittstelle erhaltene Vorgangsdaten des wenigstens einen Bildgebungsvorgangs sein.

Wie bereits erwähnt, umfassen die Hochfrequenzsignaldaten bevorzugt wenigstens einen Teil der Bilddaten des Bildgebungsvorgangs im k-Raum und/oder in einem Hybridraum und/oder im Bildraum. Hierbei ist es besonders vorteilhaft, wenn bei der Aufnahme mehrerer k-Raumabschnitte nach einem gemeinsamen Anregungspuls in einem Schuss als zusätzliche Dimension der Hochfrequenzsignaldaten des Eingangsdatensatzes die k-Raumabschnitte, insbesondere zeitlich, zu dem jeweiligen Schuss zugeordnet werden. Dabei können k-Raumabschnitte insbesondere k-Raumzeilen entsprechen. Magnetresonanzsequenzen, bei denen in zu verschiedenen Zeitpunkten erfolgenden "Schüssen", die einen gemeinsamen Anregungspuls nutzen, mehrere k-Raumzeilen aufgenommen werden, umfassend beispielsweise sogenannte TSE-Sequenzen (TSE = Turbo-Spin-Echo). k-Raumabschnitte können ferner bei anderen Aufnahmetechniken auch k-Raumsegmente, Diffusionsrepetitionen und dergleichen sein. Bei solchen zu unterschiedlichen Zeitabschnitten aufgenommenen k-Raumabschnitten kann es zweckmäßig sein, die Hochfrequenzsignaldaten in einer zusätzlichen Dimension zusammenzufassen, also zu konkatenieren, wodurch mit besonderem Vorteil dem trainierten Klassifizierungsalgorithmus eine Erkennung von zeitlichen Korrelationen erleichtert wird. Vergleichbar können zweckmäßige Ausführungsbeispiele der Erfindung vorsehen, als weitere Dimension der Hochfrequenzsignaldaten des Eingangsdatensatzes eine Zuordnung zu einem Spulenkanal, in dem sie aufgenommen wurden, zu verwenden. Eine Beibehaltung von Spulenkanälen als weitere Dimension kann den räumlichen Ursprung von Fehlwerten offenlegen und ermöglicht es dem trainierten Klassifizierungsalgorithmus allgemein, auch räumliche Korrelationen zu berücksichtigen.

In Ausgestaltung der vorliegenden Erfindung ist es ferner, insbesondere zusätzlich zu Bilddaten als Hochfrequenzsignaldaten, auch möglich, dass die Hochfrequenzsignaldaten von wenigstens einem weiteren, nicht zur Bildgebung genutzten Hochfrequenzsensor der Magnetresonanzeinrichtung aufgenommene Sensordaten umfassen. Derartige weitere Hochfrequenzsensoren können beispielsweise Pickup-Spulen und/oder einen Atemsensor umfassen. Die Bereitstellung von an verschiedenen Stellen in der Hochfrequenz-Schirmkabine angeordneten Hochfrequenzsensoren, insbesondere von Pickup-Spulen, wurde in anderem Zusammenhang bereits vorgeschlagen, um verschiedene Störeinflüsse zu detektieren. Beispielsweise kann vorgesehen sein, dass derartige Pickup-Spulen in der Patientenaufnahme, beispielsweise am Patientenaufnahmenrand, konkret der Verkleidung, und/oder am Patientisch, und/oder in oder an einer Elektronikkomponente, insbesondere einer Sendeelektronik und/oder Empfangselektronik, und/oder außerhalb der Patientenaufnahme in der Hochfrequenz-Schirmkabine angeordnet sein. Auch hier wird eine räumliche Verteilung von Hochfrequenzsignalen beschrieben, die einen Hinweis auf die Ursachen von Fehlwerten in den Bilddaten des wenigstens einen Bildgebungsvorgangs geben. Dies gilt auch für verschiedene Arten von Atemsensoren, insbesondere solche, die eine Spulen- und/oder kondensatorähnliche Anordnung verwenden, um Unterschiede in der Dielektrizitätskonfiguration des menschlichen Körpers in verschiedenen Atemzuständen zu erkennen. Auch mit solchen Atemsensoren können Hochfrequenzsignale empfangen werden, so dass diese nützlichen Informationen für den Eingangsdatensatz liefern können.

Neben den Hochfrequenzsignaldaten kann der Eingangsdatensatz auch wenigstens eine Zusatzinformation über den Bildgebungsvorgang umfassen. Solche Zusatzinformationen können die Klassifizierungsleistung deutlich verbessern und/oder weitere Detektions- und/oder Kassifizierungsergebnisse, also Erweiterungen des Ausgangsdatensatzes, unterstützen.

Konkret kann beispielsweise vorgesehen sein, dass die Zusatzinformation gewählt ist aus der Gruppe umfassend

- eine zur Bildgebung verwendete Spulen beschreibende Spuleninformation,
- eine eine Orientierung vermessener Volumina, insbesondere von Schichten, beschreibende Orientierungsinformation,
- eine während des Bildgebungsvorgangs ausgespielte Gradientenpulse, insbesondere einer Hauptgradientenrichtung, beschreibende Gradienteninformation,
- wenigstens ein Temperaturmesswert eines Temperatursensors der Magnetresonanzeinrichtung, und
- ein den Schließzustand einer Tür einer Schirmkabine der Magnetresonanzeinrichtung anzeigendes Türsensorsignal.

Während ein eine geöffnete Tür zu der Hochfrequenz-Schirmkabine anzeigendes Türsignal einen Hinweis auf außerhalb der HF-Schirmkabine liegende Ursachen geben kann, treten andere Ursachen nur in bestimmten Temperaturbereichen auf, so dass eine Temperaturinformation, konkret wenigstens ein Temperaturmesswert, ebenso eine nützliche Zusatzinformation darstellt.

Besonders vorteilhaft ist jedoch das Bereitstellen von Spuleninformationen, Orientierungsinformationen und Gradienteninformationen. Während es für die trainierte Klassifizierungsfunktion grundsätzlich, beispielsweise aufgrund von Spulenkanalzuordnungen, bereits denkbar sein kann, zu wenigstens einer Ursache eine Lokalisierungsinformation, die den Ort der Ursache beschreibt, zu ermitteln und den Ausgangsdatensatz hinzuzufügen, bieten Zusatzinformationen hier erweiterte Möglichkeiten. Insbesondere kann also vorgesehen sein, dass die trainierte Klassifizierungsfunktion unter Verwendung der Zusatzinformation, insbesondere der Spuleninformation und/oder der Orientierungsinformation und/oder der Gradienteninformation, wenigstens zu einer Ursache eine Lokalisierungsinformation, die den Ort der Ursache beschreibt, ermittelt. Beispielsweise kann ein defektes Kabel und/oder eine defekte Spulenwicklung identifiziert werden, wenn bekannt ist, wo und/oder wie die Spulen genutzt werden und/oder welche Hauptgradientenaktivität, beispielsweise bei Diffusionsmessungen, vorliegt. Dies stellt, insbesondere für einem Benutzer und auch einen Reparaturtechniker, eine wichtige und äußerst nützliche Zusatzinformation dar.

Als Ausgangsdatensatz kann mit besonderem Vorteil ein Vektor (Array) von Wahrscheinlichkeitswerten ausgegeben werden. Dabei ist jedem Eintrag des Vektors eine Ursache, beispielsweise ein Störungstyp, zugeordnet. Jeder Eintrag des Vektors kann dabei auch als ein "Kanal" verstanden werden, der einer Ursache zugeordnet ist und eine jeweilige Wahrscheinlichkeit für die Ursache enthält. Aus derartigen Wahrscheinlichkeiten kann auch eine eindeutige Klassifikation, also eine bestimmte Ursache, zumindest bei Erfüllung eines Eindeutigkeitskriteriums, ermittelt werden. Dies ist beispielsweise dann zweckmäßig, wenn die Wahrscheinlichkeit für eine bestimmte Ursache, insbesondere deutlich, höher ist als die Wahrscheinlichkeiten für alle anderen Ursachen bzw. sogar deren Summe. In diesem Zusammenhang ist es denkbar, eine Vektorposition, insbesondere die erste (beziehungsweise nullte) Vektorposition, keiner erkannten Ursache oder, wenn die trainierte Klassifizierungsfunktion auch zur Detektion des Vorliegens eines Fehlwerts ausgebildet ist, keinen erkannten Störungen, zugeordnet sein. Insbesondere kann der Ausgangsdatensatz, beispielsweise bei Ermittlung einer Lokalisierungsinformation, als Teil eines Eintrags des Vektors und/oder einer Vektorposition zugeordnet auch weitere Inhalte, beispielsweise die Lokalisierungsinformation, enthalten. Denkbar ist es selbstverständlich auch, für jede Lokalisierung eigene Einträge des Vektors vorzusehen. Allgemein umfassen mögliche Zuordnungen beispielsweise "wackelndes Gradientenkabel", "Überspannung in Gradientenspule", "Hochfrequenzstörer außerhalb der Schirmkabine", "Hochfrequenzstörer innerhalb der Schirmkabine", "Objekt in der Patientenaufnahme", und dergleichen.

In einer vorteilhaften Ausgestaltung der vorliegenden Erfindung kann die trainierte Funktion als neuronales Netzwerk ein ResNet, insbesondere ein ResNet-18, und/oder ein AlexNet und/oder ein SqueezeNet umfassen. Alle diese neuronalen Netzwerke sind CNNs, die besonders geeignet für Klassifizierungsaufgaben, insbesondere aus Bilddaten, die ja bevorzugt von den Eingangsdaten umfasst sind, sind. Allgemein kann gesagt werden, dass CNNs eine Faltungsbasis zur Erzeugung von Merkmalen aus den Eingangsdaten, insbesondere Bilddaten, aufweisen, welche insbesondere Faltungsschichten und Pooling-Schichten umfassen kann. Der Faltungsbasis folgt dann üblicherweise ein Klassifizierer, der eine oder mehrere vollständig verbundene Schichten (fully connected layers) enthalten kann. Das Hauptziel des Klassifizierers ist die Klassifizierung der Eingangsdaten basierend auf den mittels der Faltungsbasis extrahierten Merkmalen. Mit anderen Worten folgt auf eine Merkmalsextraktion in der Faltungsbasis eine Klassifizierung im Klassifizierer, um die Ausgangsdaten des Ausgangsdatensatzes bereitzustellen. Ein ResNet, kurz für "Residual Neural Network", zeichnet sich dadurch aus, dass tiefere neuronale Netzwerke geschaffen werden können, indem sogenannte "Skip Connections" oder "Shortcuts" eingesetzt werden, um Schichten zu überspringen. Die Zahlen zur Bezeichnung von ResNets, also beispielsweise 18, 34 und dergleichen, bezeichnen Schichten, obwohl die Architektur dieselbe ist. In einem ResNet existieren zwei hauptsächliche Typen von Blöcken, nämlich Identitätsblöcke, wenn die Eingangs- und Ausgangs-Aktivierungsdimensionen dieselben sind, und Faltungsblöcke, wenn die Eingangs- und Ausgangs-Aktivierungsdimensionen unterschiedlich sind. Beispielsweise kann, um die Aktivierungsdimensionen um einen Faktor von 2 zu reduzieren, eine 1x1-Faltung mit einer Schrittweite ("stride") von zwei herangezogen werden. ResNet-18 umfasst beispielsweise mehrere Faltungsblöcke in der Faltungsbasis, wobei der Klassifizierer anschließt. Zu weiteren Informationen zu ResNets sei im Übrigen auch auf den grundlegenden Artikel von K. He et al., "Deep residual learning for image recognition" (arXiv preprint arXiv:1512.03385, 2015), verwiesen. Das besonders bevorzugte ResNet-18 hat dabei den Vorteil, einen guten Kompromiss zwischen Genauigkeit und Geschwindigkeit bereitzustellen.

In vorteilhafter Weiterbildung der Erfindung kann vorgesehen sein, dass auf Basis der ausgegebenen Ausgangsdaten wenigstens eine Maßnahme ermittelt und durchgeführt wird. Es kann also basierend auf dem Ergebnis der Regression/Klassifikation die Ableitung einer Maßnahme erfolgen. Insofern ist die Ausgabe wenigstens eines Teils der Ausgangsdaten des Ausgangsdatensatzes in diesem Fall als eine Weitergabe an eine Maßnahmeneinheit zu verstehen. Die wenigstens eine Maßnahme kann aus der Gruppe umfassend

- einen Fehlerspeichereintrag speichern,
- einen, insbesondere auf die ausgegebenen Ausgangsdaten bezogenen und/oder diese enthaltenden, Hinweis an einen Benutzer ausgeben,

- eine, insbesondere auf die ausgegebenen Ausgangsdaten bezogene und/oder diese enthaltende, Meldung an einen Wartungsdienst senden, und
- einen, insbesondere anhand der ausgegebenen Ausgangsdatengewählten und/oder diese nutzenden, Korrekturalgorithmus auf die Bilddaten anwenden,

gewählt wird.

Neben häufig zweckmäßigen Einträgen in einen Fehlerspeicher ist eine Meldung an eine Remote-Serviceüberwachung, insbesondere im Rahmen einer Predictive Maintenance, beziehungsweise die Ausgabe einer Warnung an Bedienpersonal äußerst zweckmäßig. Eine Meldung an einen Wartungsdienst kann beispielsweise einen Hinweis enthalten, dass Kabel- und/oder Gradientenspulen und/oder Hochfrequenzverstärker und/oder andere Komponenten überprüft werden müssen. Die Ausgabe einer Warnung an Bedienpersonal kann beispielsweise "Störsignale festgestellt. Bitte Überprüfen Sie, ob die Tür zum Scannerraum geschlossen ist.", "Störsignale festgestellt. Bitte überprüfen Sie, ob sich Netzteile, defekte Leuchtstoffröhren, etc. im Scannerraum befinden." "Störsignale festgestellt. Bitte überprüfen Sie, ob sich Metallteile in der Patientenaufnahme befinden." oder vergleichbar lauten.

Die Klassifizierung der Ursache des Fehlwerts kann auch zur Auswahl einer geeigneten Fehlerkorrekturmaßnahme genutzt werden. Beispielsweise kann ein geeigneter Korrekturalgorithmus ausgewählt werden, insbesondere ein neuronales Netzwerk zur Beseitigung zufälliger Störungen und/oder sonstige Korrekturalgorithmen, beispielsweise ein Abschneiden der ersten beiden Datenpunkte jeder k-Raumlinie und dergleichen. Mithin kann die Beseitigung der Störung gezielt optimal gemäß deren Ursache gewählt werden und daher auch die Korrektur der durch den Fehlwert eintretenden Bildeffekte verbessert werden.

Zur Bereitstellung der trainierten Klassifizierungsfunktion wird die Klassifizierungsfunktion mit geeigneten Trainingsdatensätzen trainiert. Hierbei ist grundsätzlich auch alleinstehend ein Bereitstellungsverfahren zur Bereitstellung der trainierten Klassifizierungsfunktion denkbar, welches das Bereitstellen der zu trainierenden Klassifizierungsfunktion und von Trainingsdatensätzen über eine erste Trainingsschnittstelle, ein Trainieren der Klassifizierungsfunktion auf Grundlage der Trainingsdatensätze mittels eines Prozessors sowie ein Bereitstellen der trainierten Klassifizierungsinformation über eine zweite Trainingsschnittstelle umfassen kann. Dabei erfolgt ein Training der Klassifizierungsfunktion insbesondere auf der Grundlage annotierter Eingangsdatensätze, denen mithin eine Grundwahrheit zugeordnet ist. Da Spike-Fehlwerte in der Regel gehäuft auftreten, sind im Fehlerfall üblicherweise viele betroffene Bilddaten vorhanden. Dennoch kann es eine Herausforderung darstellen, für unterschiedliche Ursachen eine große Anzahl an geeigneten Datensätzen zu erhalten.

Eine besonders vorteilhafte Weiterbildung der vorliegenden Erfindung sieht daher vor, dass zur Bereitstellung der trainierten Klassifizierungsfunktion eine vortrainierte Klassifizierungsfunktion bereitgestellt wird und mittels Transferlernen auf Grundlage von Trainingsdatensätzen trainiert wird, wobei jeder Trainingsdatensatz einen Eingangsdatensatz und eine zugeordnete Grundwahrheit umfasst. Die zugeordnete Grundwahrheit kann bereits als der entsprechende Ausgangsdatensatz formuliert sein. Mithin wird vorgeschlagen, ein vortrainiertes Modell, beispielsweise ResNet-18, mittels Transferlernens anzupassen, um die Anzahl an benötigten Trainingsdatensätzen in Grenzen zu halten.

Als vortrainierte Funktionen werden meist CNNs bereitgestellt, wobei im Rahmen der vorliegenden Erfindung, wie bereits dargelegt, mit besonderem Vorteil eine ein ResNet, insbesondere ein ResNet-18, umfassende Klassifizierungsfunktion verwendet werden kann.

Ferner kann es im Rahmen des Trainings zweckmäßig sein, wenn wenigstens ein Teil der Eingangsdatensätze der Trainingsdatensätze aus fehlwertfreien Basisdatensätzen mittels einer Ursachen zugeordneten Charakteristika-Information ermittelt wird. Es ist also möglich, Trainingsdatensätze zu synthetisieren, wenn die Charakteristika der Ursachen gut nachgebildet werden können. Beispielsweise kann vorgesehen sein, aus einem Eingangsdatensatz von spikefreien Eingangsdaten eine Vielzahl von Eingangsdatensätzen mit unterschiedlichen Spike-Ursachen zu synthetisieren. Auf diese Weise kann eine zusätzliche Trainingsgrundlage geschaffen werden.

Insgesamt und zusammenfassend kann also gesagt werden, dass durch die erfindungsgemäß vorgeschlagene Klassifikation der Ursache von Störeinflüssen, insbesondere Spike-Fehlwerten, eine Reduzierung von Technikereinsätzen, ein Ausbau der prädiktiven Wartung (predictive maintenance) sowie eine schnellere Lösungsbehebung durch den Benutzer selbst im Sinne einer "Hilfe zur Selbsthilfe" erreicht werden kann.

Ein erfindungsgemäßes Computerprogramm ist direkt in einen Speicher einer Recheneinrichtung, insbesondere einer Steuereinrichtung einer Magnetresonanzeinrichtung, ladbar und weist Programmmittel derart auf, dass bei Ausführen des Computerprogramms auf der Recheneinrichtung diese die Schritte eines erfindungsgemäßen Verfahrens durchführt. Das Computerprogramm kann auf einem erfindungsgemäßen elektronisch lesbaren Datenträger gespeichert sein, so dass bei Verwendung des Datenträgers in einer Recheneinrichtung, insbesondere einer Steuereinrichtung einer Magnetresonanzeinrichtung, diese ausgebildet wird, ein erfindungsgemäßes Verfahren durchzuführen. Der erfindungsgemäße elektronisch lesbare Datenträger ist dabei insbesondere ein nichttransienter Datenträger. Ein entsprechendes Trainingscomputerprogramm und ein entsprechender Trainingsdatenträger sind auch für das denkbare Trainingsverfahren entsprechend denkbar.

Die Erfindung betrifft schließlich auch eine Recheneinrichtung, insbesondere eine Steuereinrichtung einer Magnetresonanzeinrichtung, welche zur Ermittlung wenigstens einer potentiellen Ursache für einen Fehlwert, insbesondere einen Spike-Fehlwert, in den Bilddaten wenigstens eines Bildgebungsvorgangs aufweist:

- eine erste Schnittstelle zum Erhalt von den Bildgebungsvorgang beschreibenden Vorgangsdaten, welche zumindest während dem Bildgebungsvorgang erfasste Hochfrequenzsignaldaten umfassen,
- eine Zusammenstellungseinheit zur Zusammenstellung eines zu analysierenden Eingangsdatensatzes, der zumindest einen Teil der Hochfrequenzsignaldaten enthält, aus den Vorgangsdaten,
- eine Klassifizierungseinheit zum Anwenden einer trainierten Klassifizierungsfunktion der künstlichen Intelligenz auf den Eingangsdatensatz zur Ermittlung eines Ausgangsdatensatzes, der potentielle Ursachen des Fehlwerts beschreibt,
- eine zweite Schnittstelle zur Ausgabe wenigstens eines Teils der Ausgangsdaten des Ausgangsdatensatzes.

Sämtliche Ausführungen bezüglich des erfindungsgemäßen Verfahrens lassen sich analog auf die erfindungsgemäße Recheneinrichtung, das Computerprogramm und den elektronisch lesbaren Datenträger übertragen, so dass auch mit diesen die bereits genannten Vorteile erhalten werden können.

Die erfindungsgemäße Recheneinrichtung weist bevorzugt wenigstens einen Prozessor und wenigstens ein Speichermittel auf. Die genannten Funktionseinheiten können wenigstens teilweise durch Hardware und/oder wenigstens teilweise durch Software, insbesondere durch Programmmittel des erfindungsgemäßen Computerprogramms, gebildet sein. Neben den genannten Funktionseinheiten, also Zusammenstellungseinheit und Klassifizierungseinheit, kann die Recheneinrichtung selbstverständlich auch weitere Funktionseinheiten zur Realisierung weiterer Schritte des erfindungsgemäßen Verfahrens aufweisen, beispielsweise eine Maßnahmeneinheit und gegebenenfalls sogar eine Trainingseinheit. Auch ein getrenntes Trainingssystem zur Durchführung des denkbaren Bereitstellungsverfahrens für die trainierte Klassifizierungsfunktion ist denkbar. Zweckmäßigerweise handelt es sich bei der Recheneinrichtung um eine Steuereinrichtung einer Magnetresonanzeinrichtung. In diesem Fall kann an der Magnetresonanzeinrichtung unmittelbar eine Überprüfung von Bildgebungsvorgängen stattfinden und bei auftretenden Hochfrequenzstörungen, insbesondere Spike-Fehlwerten, kann unmittelbar vor Ort eine Klassifizierung der Ursachen erfolgen. Dies ermöglicht es beispielsweise, unmittelbar an der Magnetresonanzeinrichtung bereits Hinweise an Benutzer auszugeben und/oder unmittelbar geeignete Korrekturmaßnahmen auszuwählen beziehungsweise Korrekturmaßnahmen anzupassen.

Weitere Vorteile und Einzelheiten der vorliegenden Erfindung ergeben sich aus den im Folgenden beschriebenen Ausführungsbeispielen sowie anhand der Zeichnungen. Dabei zeigen:

Fig. 1 ein Ausführungsbeispiel eines künstlichen neuronalen Netzes,

Fig. 2 ein Ausführungsbeispiel eines Convolutional Neural Network,

Fig. 3 einen Ablaufplan eines Ausführungsbeispiels des erfindungsgemäßen Verfahrens,

Fig. 4 eine erläuternde Darstellung zur Vorbereitung von Eingangsdaten,

Fig. 5 schematisch die Struktur einer verwendeten trainierten Klassifizierungsfunktion,

Fig. 6 Schritte zum Training der trainierten Klassifizierungsfunktion,

Fig. 7 den funktionalen Aufbau einer erfindungsgemäßen Recheneinrichtung, und

Fig. 8 eine Magnetresonanzeinrichtung.

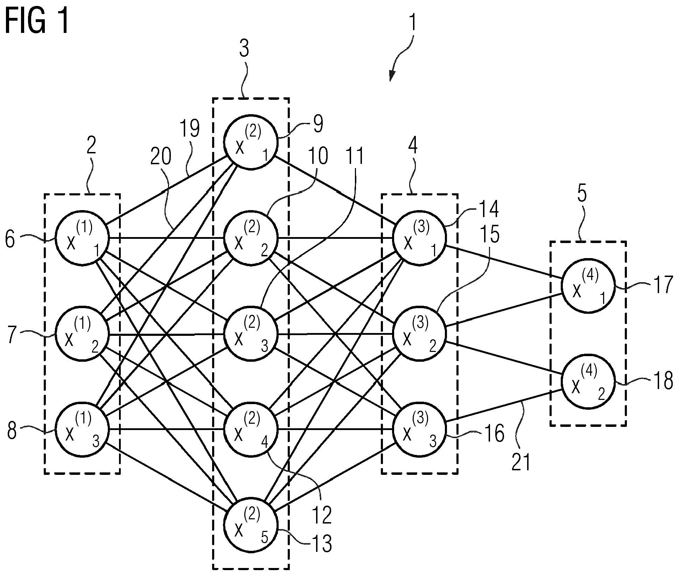

Fig. 1 zeigt ein Ausführungsbeispiel eines künstlichen neuronalen Netzes 1. Englische Ausdrücke für das künstliche neuronale Netz 1 sind "artificial neural network", "neural network", "artificial neural net" oder "neural net".

Das künstliche neuronale Netzwerk 1 umfasst Knoten 6 bis 18 (nodes) und Kanten 19 bis 21 (edges), wobei jede Kante 19 bis 21 eine gerichtete Verbindung von einem ersten Knoten 6 bis 18 zu einem zweiten Knoten 6 bis 18 ist. Im Allgemeinen sind der erste Knoten 6 bis 18 und der zweite Knoten 6 bis 18 unterschiedliche Knoten 6 bis 18, es ist jedoch auch denkbar, dass der erste Knoten 6 bis 18 und der zweite Knoten 6 bis 18 identisch sind. Beispielsweise ist in Fig. 1 die Kante 19 eine gerichtete Verbindung von dem Knoten 6 zu dem Knoten 9 und die Kante 21 ist eine gerichtete Verbindung von dem Knoten 16 zu dem Knoten 18. Eine Kante 19 bis 21 von einem ersten Knoten 6 bis 18 zu einem zweiten Knoten 6 bis 18 wird als eingehende Kante ("ingoing edge") für den zweiten Knoten 6 bis 18 und als ausgehende Kante ("outgoing edge") für den ersten Knoten 6 bis 18 bezeichnet.

In diesem Ausführungsbeispiel können die Knoten 6 bis 18 des künstlichen neuronalen Netzes 1 in Schichten 2 bis 5 (layers) angeordnet werden, wobei die Schichten eine intrinsische Ordnung aufweisen können, die durch die Kanten 19 bis 21 zwischen den Knoten 6 bis 18 eingeführt wird. Insbesondere können Kanten 19 bis 21 nur zwischen benachbarten Schichten von Knoten 6 bis 18 vorgesehen sein. Im dargestellten Ausführungsbeispiel existiert eine Eingabeschicht 2, die lediglich die Knoten 6, 7, 8 aufweist, jeweils ohne eingehende Kante. Die Ausgangsschicht 5 umfasst nur die Knoten 17, 18, jeweils ohne ausgehende Kanten, wobei ferner versteckte Schichten 3 und 4 zwischen der Eingangsschicht 2 und der Ausgangsschicht 5 liegen. Im allgemeinen Fall kann die Zahl der versteckten Schichten 3, 4 beliebig gewählt werden. Die Zahl der Knoten 6, 7, 8 der Eingangsschicht 2 entspricht üblicherweise der Zahl der Eingabewerte in das neuronale Netzwerk 1, und die Zahl der Knoten 17, 18 in der Ausgangsschicht 5 entspricht üblicherweise der Zahl der Ausgabewerte des neuronalen Netzwerks 1.

Insbesondere kann eine (reale) Zahl den Knoten 6 bis 18 des neuronalen Netzwerks 1 zugeordnet werden. Dabei bezeichnet $x^{(n)}_i$ den Wert des i-ten Knotens 6 bis 18 der n-ten Schicht 2 bis 5. Die Werte der Knoten 6, 7, 8 der Eingabeschicht 2 sind äquivalent zu den Eingabewerten des neuronalen Netzwerks 1, während die Werte der Knoten 17, 18 der Ausgangsschicht 5 äquivalent zu den Ausgabewerten des neuronalen Netzwerks 1 sind. Darüber hinaus kann jeder Kante 19, 20, 21 ein Gewicht in Form einer realen Zahl zugeordnet sein. Insbesondere ist das Gewicht eine reale Zahl im Intervall [-1, 1] oder im Intervall [0, 1,]. Dabei bezeichnet $w^{(m,n)}_{i,j}$ das Gewicht der Kante zwischen den i-ten Knoten 6 bis 18 der m-ten Schicht 2 bis 5 und den j-ten Knoten 6 bis 18 der n-ten Schicht 2 bis 5. Ferner wird die Abkürzung $w^{(n)}_{i,j}$ für das Gewicht $w^{(n,n+1)}_{i,j}$ definiert.

Um Ausgangswerte des neuronalen Netzes 1 zu berechnen, werden die Eingangswerte durch das neuronale Netz 1 propagiert. Insbesondere können die Werte der Knoten 6 bis 18 des (n+1)-ten Schicht 2 bis 5 basierend auf den Werten der Knoten 6 bis 18 der n-ten Schicht 2 bis 5 berechnet werden durch

$$x^{(n+1)}_j = f\left(\sum_i x^{(n)}_i \cdot w^{(n)}_{i,j}\right).$$

Dabei ist f eine Transferfunktion, die auch als Aktivierungsfunktion bezeichnet werden kann. Bekannte Transferfunktionen sind Stufenfunktionen, Sigmoidfunktionen (beispielsweise die logistische Funktion, die verallgemeinerte logistische Funktion, der Tangens hyperbolicus, der Arkustangens, die Fehlerfunktion, die Smoothstep-Funktion) oder Gleichrichterfunktionen (Rectifier). Die Transferfunktion wird im Wesentlichen für Normierungszwecke verwendet.

Insbesondere werden die Werte schichtweise durch das neuronale Netz 1 propagiert, wobei Werte der Eingangsschicht 2 durch die Eingangsdaten des neuronalen Netzes 1 gegeben sind. Werte der ersten versteckten Schicht 3 können basierend auf den Werten der Eingangsschicht 2 des neuronalen Netzes 1 berechnet werden, Werte der zweiten versteckten Schicht 4 können basierend auf den Werten in der ersten versteckten Schicht 3 berechnet werden usw.

Um die Werte $w^{(n)}_{i,j}$ für die Kanten 19 bis 21 festlegen zu können, muss das neuronale Netz 1 unter Verwendung von Trainingsdaten trainiert werden. Insbesondere umfassen Trainingsdaten Trainingseingangsdaten und Trainingsausgangsdaten, die im Folgenden als $t_i$ bezeichnet werden. Für einen Trainingsschritt wird das neuronale Netzwerk 1 auf die Trainingseingangsdaten angewendet, um berechnete Ausgangsdaten zu ermitteln. Insbesondere umfassen die Trainingsausgangsdaten und die berechneten Ausgangsdaten eine Zahl von Werten, wobei sich die Zahl als die Zahl der Knoten 17, 18 der Ausgangsschicht 5 bestimmt.

Insbesondere wird ein Vergleich zwischen den berechneten Ausgangsdaten und den Trainingsausgangsdaten verwendet, um die Gewichte innerhalb des neuronalen Netzes 1 rekursiv anzupassen (Rückpropagierungsalgorithmus - "back propagation algorithm"). Insbesondere können die Gewichte entsprechend

$$w'^{(n)}_{i,j} = w^{(n)}_{i,j} - \gamma \cdot \delta^{(n)}_j \cdot x^{(n)}_i$$

geändert werden, wobei $\gamma$ eine Lernrate ist und die Zahlen $\delta^{(n)}_j$ rekursiv berechnet werden können als

$$\delta^{(n)}_j = \left(\sum_k \delta^{(n+1)}_k \cdot w^{(n+1)}_{j,k}\right) \cdot f'\left(\sum_i x^{(n)}_i \cdot w^{(n)}_{i,j}\right)$$

basierend auf $\delta_j^{(n+1)}$ , wenn die (n+1)-te Schicht nicht die Ausgangsschicht 5 ist, und

$$\delta_j^{(n)} = \left(x_k^{(n+1)} - t_j^{(n+1)}\right) \cdot f' \left(\sum_i x_i^{(n)} \cdot w_{i,j}^{(n)}\right)$$

falls die (n+1)-te Schicht die Ausgangsschicht 5 ist, wobei f' die erste Ableitung der Aktivierungsfunktion ist und $y_j^{(n+1)}$ der Vergleichstrainingswert für den j-ten Knoten 17, 18 der Ausgangsschicht 5 ist.

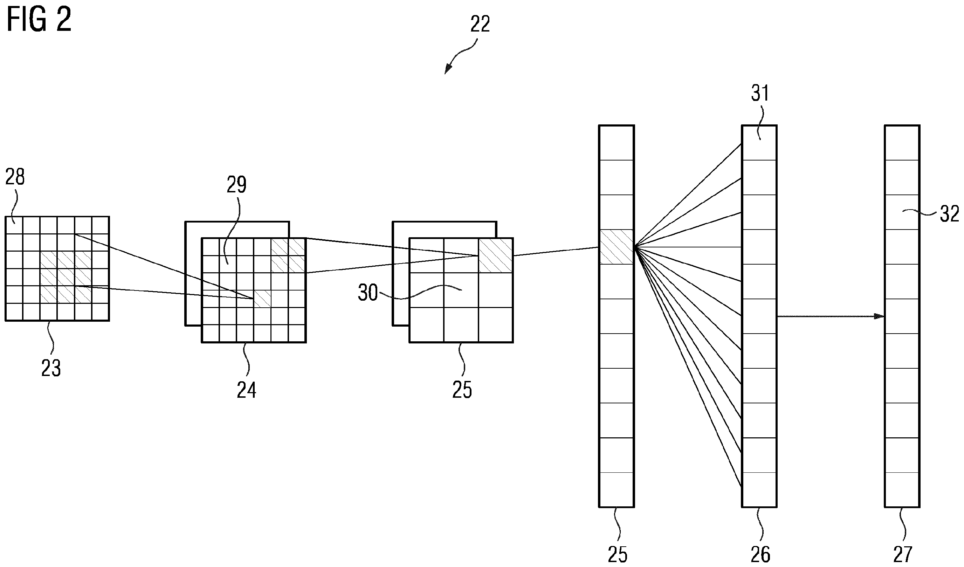

Im Folgenden wird im Hinblick auf Fig. 2 auch ein Beispiel für ein Convolutional Neural Network (CNN) gegeben. Dabei ist zu beachten, dass der Ausdruck "Schicht" ("layer") dort auf leicht andere Art und Weise als für klassische neuronale Netze eingesetzt wird. Für ein klassisches neuronales Netz verweist der Ausdruck "Schicht" nur auf den Satz von Knoten, der eine Schicht bildet, mithin eine bestimmte Generation von Knoten. Für ein Convolutional Neural Network, wird der Ausdruck "Schicht" oft als ein Objekt benutzt, das aktiv Daten verändert, in anderen Worten als ein Satz von Knoten derselben Generation und entweder den Satz eingehender oder ausgehender Kanten.

Fig. 2 zeigt ein Ausführungsbeispiel eines Convolutional Neural Network 22. In dem dargestellten Ausführungsbeispiel umfasst das Convolutional Neural Network 22 eine Eingangsschicht 23, eine Faltungsschicht 24 (Convolutional Layer), eine Pooling-Schicht 25, eine vollständig verbundene Schicht 26 und eine Ausgangsschicht 27. In alternativen Ausgestaltungen kann das Convolutional Neural Network 22 mehrere Faltungsschichten 24, mehrere Pooling-Schichten 25 und mehrere vollständig verbundene Schichten 26, genau wie andere Arten von Schichten, enthalten. Die Reihenfolge der Schichten kann beliebig gewählt werden, wobei üblicherweise vollständig verbundene Schichten 26 die letzten Schichten vor der Ausgangsschicht 27 bilden.

Insbesondere können innerhalb eines Convolutional Neural Network 22 die Knoten 28 bis 32 einer der Schichten 23 bis 27 als in einer d-dimensionalen Matrix oder als d-dimensionales Bild angeordnet verstanden werden. Insbesondere kann im zweidimensionalen Fall der Wert eines Knotens 28 bis 32 mit den Indizes i, j in der n-ten Schicht 23 bis 27 als $x^{(n)}$ [i,j] bezeichnet werden. Es ist darauf hinzuweisen, dass die Anordnung der Knoten 28 bis 31 einer Schicht 23 bis 27 keinerlei Auswirkung auf die Berechnungen innerhalb des Convolutional Neural Network 22 als solches hat, da diese Auswirkungen ausschließlich durch die Struktur und die Gewichte der Kanten gegeben sind.

Eine Faltungsschicht 24 ist insbesondere dadurch ausgezeichnet, dass die Struktur und die Gewichte der eingehenden Kanten eine Faltungsoperation basierend auf einer bestimmten Zahl von Kernen bildet. Insbesondere können die Struktur und die Gewichte der eingehenden Kanten so gewählt werden, dass die Werte $x_k^{(n)}$ der Knoten 29 der Faltungsschicht 24 als eine Faltung $x_k^{(n)} = K_k * x^{(n-1)}$ basierend auf den Werten $x^{(n-1)}$ der Knoten 28 der vorangehenden Schicht 23 ermittelt werden, wobei die Faltung * im zweidimensionalen Fall definiert werden kann als

$$x_k^{(n)}[i,j] = \left(K_k * x^{(n-1)}\right)[i,j] = \sum_{i'} \sum_{j'} K_k[i',j'] \cdot x^{(n-1)}[i-i', j-j'].$$

Darin ist der k-te Kern $K_k$ eine d-dimensionale Matrix, in diesem Ausführungsbeispiel eine zweidimensionale Matrix, die üblicherweise klein im Vergleich zur Zahl der Knoten 28 bis 32 ist, beispielsweise eine 3x3-Matrix oder eine 5x5-Matrix. Insbesondere impliziert dies, dass die Gewichte der eingehenden Kanten nicht unabhängig sind, sondern so gewählt sind, dass sie obige Faltungsgleichung erzeugen. Im Beispiel für einen Kern, der eine 3x3-Matrix bildet, existieren nur neun unabhängige Gewichte (wobei jeder Eintrag der Kern-Matrix einem unabhängigen Gewicht entspricht), ungeachtet der Zahl der Knoten 28 bis 32 in der entsprechenden Schicht 23 bis 27. Insbesondere ist für eine Faltungsschicht 24 die Zahl der Knoten 29 in der Faltungsschicht 24 äquivalent der Zahl der Knoten 28 in der vorangehenden Schicht 23 multipliziert mit der Zahl der Faltungskerne.

Wenn die Knoten 28 der vorangehenden Schicht 23 als eine d-dimensionale Matrix angeordnet sind, kann die Nutzung der Mehrzahl von Kernen als Hinzufügung einer weiteren Dimension, die auch als Tiefendimension bezeichnet wird, verstanden werden, so dass die Knoten 29 der Faltungsschicht 24 als eine (d+1)-dimensionale Matrix angeordnet sind. Wenn die Knoten 28 der vorangehenden Schicht 23 bereits als eine (d+1)-dimensionale Matrix mit einer Tiefendimension angeordnet sind, kann die Nutzung einer Mehrzahl von Faltungskernen als Expansion entlang der Tiefendimension verstanden werden, so dass die Knoten 29 der Faltungsschicht 24 gleichermaßen als eine (d+1)-dimensionale Matrix angeordnet sind, wobei die Größe der (d+1)-dimensionalen Matrix in der Tiefendimension um den durch die Zahl der Kerne gebildeten Faktor größer ist als in der vorangehenden Schicht 23.

Der Vorteil der Nutzung von Faltungsschichten 24 ist, dass die räumlich lokale Korrelation der Eingangsdaten ausgenutzt werden kann, indem ein lokales Verbindungsmuster zwischen Knoten benachbarter Schichten geschaffen wird, insbesondere dadurch, dass jeder Knoten nur zu einem kleinen Bereich der Knoten der vorangehenden Schicht Verbindungen aufweist.

Im dargestellten Ausführungsbeispiel umfasst die Eingangsschicht 23 sechsunddreißig Knoten 28, die als eine zweidimensionale 6x6-Matrix angeordnet sind. Die Faltungsschicht 24 umfasst zweiundsiebzig Knoten 29, die als zwei zweidimensionale 6x6-Matrizen angeordnet sind, wobei jede der beiden Matrizen das Ergebnis einer Faltung der Werte der Eingangsschicht 23 mit einem Faltungskern ist. In gleicher Weise können die Knoten 29 der Faltungsschicht 24 als in einer dreidimensionalen 6x6x2-Matrix angeordnet verstanden werden, wobei die zuletzt genannte Dimension die Tiefendimension ist.

Eine Pooling-Schicht 25 zeichnet sich dadurch aus, dass die Struktur und die Gewichte der eingehenden Kanten sowie die Aktivierungsfunktion ihrer Knoten 30 eine Pooling-Operation basierend auf einer nichtlinearen Pooling-Funktion f definieren. Beispielsweise können im zweidimensionalen Fall die Werte $x^{(n)}$ der Knoten 30 der Pooling-Schicht 25 basierend auf den Werten $x^{(n+1)}$ der Knoten 29 der vorangehenden Schicht 24 als

$$x^{(n)}[i,j] = f(x^{(n-1)}[id_1, jd_2], \ldots, x^{(n-1)}[id_1+d_1-1, jd_2+d_2-1])$$

berechnet werden. In anderen Worten kann durch die Verwendung einer Pooling-Schicht 25 die Zahl der Knoten 29, 30 reduziert werden, indem eine Anzahl von $d_1 \times d_2$ benachbarter Knoten 29 in der vorangehenden Schicht 24 durch einen einzelnen Knoten 30 ersetzt werden, der als eine Funktion der Werte der genannten Anzahl benachbarter Knoten 29 berechnet wird. Insbesondere kann die Pooling-Funktion f eine Maximumsfunktion, eine Durchschnittsbildung oder die L2-Norm sein. Insbesondere können für eine Pooling-Schicht 25 die Gewichte der eingehenden Kanten festgelegt sein und nicht durch Training modifiziert sein.

Der Vorteil der Verwendung einer Pooling-Schicht 25 ist, dass die Zahl der Knoten 29, 30 und die Zahl der Parameter reduziert wird. Dies führt zu einer Reduktion der notwendigen Berechnungsmenge innerhalb des Convolutional Neural Network 22 und somit zu einer Steuerung der Überanpassung.

Im dargestellten Ausführungsbeispiel handelt es sich bei der Pooling-Schicht 25 um eine Max-Pooling-Schicht, in der vier benachbarte Knoten mit nur einem einzigen Knoten ersetzt werden, dessen Wert durch das Maximum der Werte der vier benachbarten Knoten gebildet wird. Das Max-Pooling wird auf jede d-dimensionale Matrix der vorherigen Schicht angewendet; in diesem Ausführungsbeispiel wird das Max-Pooling auf jede der zwei zweidimensionalen Matrizen angewendet, so dass sich die Zahl der Knoten von zweiundsiebzig auf achtzehn reduziert.

Eine vollständig verbundene Schicht 26 zeichnet sich dadurch aus, dass eine Mehrzahl, insbesondere alle, Kanten zwischen den Knoten 30 der vorherigen Schicht 25 und den Knoten 31 der vollständig verbundenen Schicht 26 vorhanden sind, wobei das Gewicht jeder der Kanten individuell angepasst werden kann. In diesem Ausführungsbeispiel werden die Knoten 30 der vorangehenden Schicht 25 und der vollständig verbundenen Schicht 26 sowohl als zweidimensionale Matrizen als auch als nichtzusammenhängende Knoten (dargestellt als eine Zeile von Knoten, wobei die Zahl der Knoten zur besseren Darstellbarkeit reduziert wurde) gezeigt. In diesem Ausführungsbeispiel ist die Zahl der Knoten 31 in der vollständig verbundenen Schicht 26 gleich der Anzahl der Knoten 30 in der vorangehenden Schicht 25. In alternativen Ausführungsformen kann die Zahl der Knoten 30, 31 unterschiedlich sein.

Darüber hinaus werden in diesem Ausführungsbeispiel die Werte der Knoten 32 der Ausgangsschicht 27 bestimmt, indem die Softmax-Funktion auf die Werte der Knoten 31 der vorangehenden Schicht 26 angewendet wird. Durch Anwendung der Softmax-Funktion ist die Summe der Werte aller Knoten 32 der Ausgangsschicht 27 eins und alle Werte aller Knoten 32 der Ausgangsschicht sind reale Zahlen zwischen 0 und 1. Wenn das Convolutional Neural Network 22 zur Klassifizierung von Eingangsdaten genutzt wird, können insbesondere die Werte der Ausgangsschicht 27 als Wahrscheinlichkeit dafür interpretiert werden, dass die Eingangsdaten in eine der unterschiedlichen Klassen fallen.

Ein Convolutional Neural Network 22 kann ebenso eine ReLU-Schicht aufweisen, wobei ReLU als Akronym für "rectified linear units" steht. Insbesondere ist die Zahl der Knoten und die Struktur der Knoten innerhalb einer ReLU-Schicht äquivalent zu der Zahl der Knoten und der Strukturen der Knoten der vorangehenden Schicht. Der Wert jedes Knotens in der ReLU-Schicht kann insbesondere durch Anwendung einer Gleichrichtungsfunktion (rectifier function) auf den Wert des entsprechenden Knoten der vorangehenden Schicht berechnet werden. Beispiele für Gleichrichterfunktionen sind f(x)=max(0,x), der Tangens hyperbolicus oder die Sigmoidfunktion.

Convolutional Neural Networks 22 können insbesondere basierend auf den Rückpropagierungsalgorithmus trainiert werden. Um eine Überanpassung (overfitting) zu vermeiden, können Verfahren der Regularisierung eingesetzt werden, beispielsweise Dropout einzelner Knoten 28 bis 32, stochastisches Pooling, Nutzen von künstlichen Daten, Gewichtszerfall basierend auf der L1- oder der L2-Norm oder Maximalnorm-Einschränkungen.

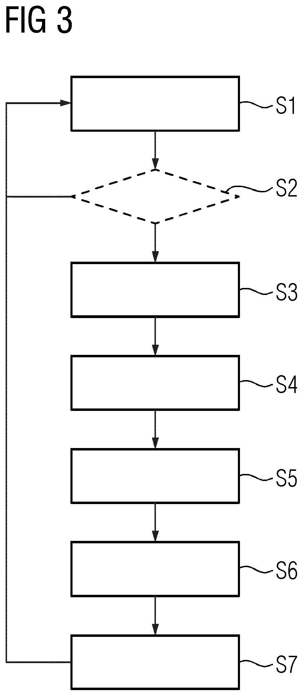

Fig. 3 zeigt einen Ablaufplan eines Ausführungsbeispiels des erfindungsgemäßen Verfahrens zum Betrieb einer Magnetresonanzeinrichtung, an der in Untersuchungsvorgängen von Objekten, hier Patienten, Bilddaten in Bildgebungsvorgängen aufgenommen werden. Die Magnetresonanzeinrichtung umfasst dabei, wie grundsätzlich bekannt, eine Hauptmagneteinheit mit einer zylindrischen Patientenaufnahme, in die der Patient mittels einer Patientenliege eingefahren werden kann. Die Hauptmagneteinheit enthält einen insbesondere supraleitenden Hauptmagneten zur Erzeugung eines Hauptmagnetfelds. Die Patientenaufnahme umgebend können eine Hochfrequenzspulenanordnung und eine Gradientenspulenanordnung vorgesehen sein; als weitere Hochfrequenzspulenanordnungen können auch Lokalspulen und dergleichen verwendet werden. Die Hauptmagneteinheit ist in einer Hochfrequenz-Schirmkabine angeordnet. Dabei kann sich wenigstens ein Teil einer das Verfahren durchführenden und auch den sonstigen Betrieb der Magnetresonanzeinrichtung steuernden Steuereinrichtung auch außerhalb der Schirmkabine befinden.

Konkret werden in einem Schritt S1 Bilddaten in einem Bildgebungsvorgang aufgenommen. In einem optionalen Schritt S2 kann überprüft werden, beispielsweise mittels einer geeigneten Detektionsfunktion, ob in den Bilddaten, konkret den Messwerten im k-Raum, Spike-Fehlwerte enthalten sind. Ist dies nicht der Fall, wird mit dem nächsten Bildgebungsvorgang fortgefahren. Diese Funktion, Spike-Fehlwerte, also lokale Überhöhungen der Intensitäten, insbesondere Peaks und/oder Signalspitzen, die nicht das Objekt beschreiben, festzustellen, kann auch in der im Folgenden noch zu diskutierenden trainierten Klassifizierungsfunktion integriert sein. Dann würde an den Schritt S1, gegebenenfalls auch nach mehreren Bildgebungsvorgängen im Schritt S1, unmittelbar der Schritt S3 anschließen.

Im Schritt S3 werden aus Vorgangsdaten zu dem Bildgebungsvorgang Eingangsdaten eines Eingangsdatensatzes für den trainierten Klassifizierungsalgorithmus zusammengestellt. Vorliegend umfassen die Eingangsdaten des Eingangsdatensatzes in jedem Fall die Bilddaten im k-Raum und/oder einem Hybridraum und/oder im Bildraum als Hochfrequenzsignaldaten. Diese Hochfrequenzsignaldaten, die ja empfangene Hochfrequenzsignale betreffen, die auch für den entsprechenden Spike verantwortlich sind, können auch von wenigstens einem weiteren, nicht zur Bildgebung genutzten Hochfrequenzsensor oder Atemsensor aufgenommene Sensordaten umfassen. Derartige weitere Hochfrequenzsensoren können beispielsweise Pickup-Spulen, die an verschiedenen Stellen in der Schirmkabine vorgesehen werden können, und/oder einen Atemsensor umfassen.

Im Rahmen der Zusammenstellung werden den Bilddaten vorliegend zwei neue Dimensionen hinzugefügt, nämlich zum einen die räumliche Information enthaltenden Spulenkanäle, in denen die jeweiligen Signale aufgenommen wurden, zum anderen aber auch die Zeitabschnitte, in denen bestimmte k-Raumabschnitte, beispielsweise k-Raumzeilen, aufgenommen wurden, konkret den jeweiligen Schuss.

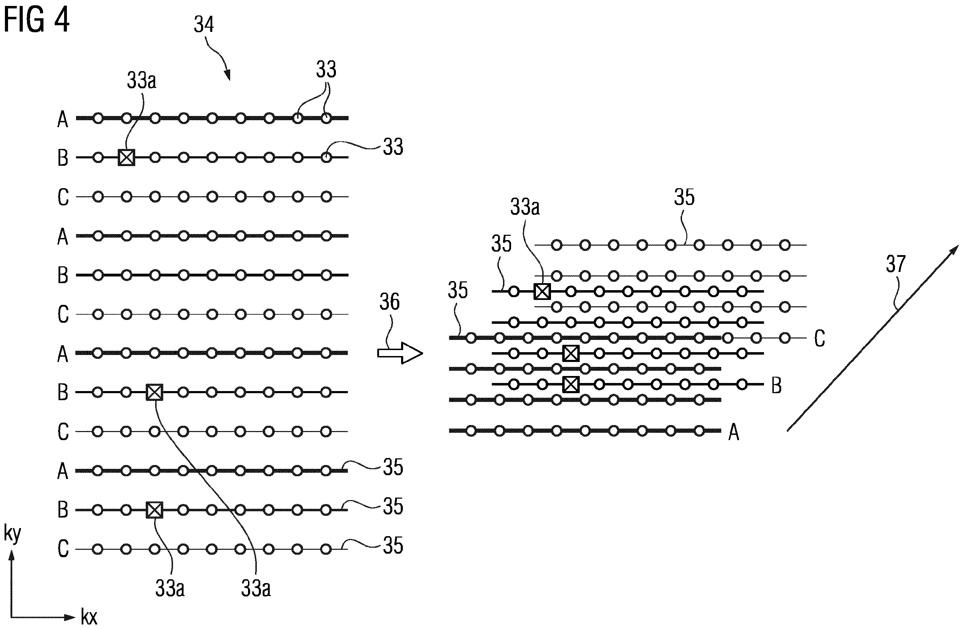

Dies wird durch Fig. 4 näher erläutert. Diese zeigt auf der linken Seite schematisch einen an verschiedenen Messpunkten 33 abgetasteten k-Raum mit den Richtungen kx und ky. Hierbei wurden als k-Raumabschnitte 34 k-Raumlinien 35 in drei Schüssen aufgenommen, die hier mit A, B, C gekennzeichnet sind. Das bedeutet, die mit A gekennzeichneten k-Raumlinien 35 sind in einem ersten Zeitabschnitt nach einem gemeinsamen Anregungspuls aufgenommen worden, die mit B gekennzeichneten k-Raumzeilen 35 sind in einem zweiten Zeitabschnitt nach einem gemeinsamen Anregungspuls aufgenommen worden und die mit C gekennzeichneten k-Raumzeilen 35 sind zu einem dritten Zeitabschnitt nach einem gemeinsamen Anregungspuls aufgenommen worden. Vorliegend sind beispielhaft einige k-Raumpunkte 33a besonders gekennzeichnet, nachdem an diesen k-Raumpunkten 33a Spike-Fehlwerte vorliegen. Ersichtlich liegen alle diese k-Raumpunkte 33a auf k-Raumzeilen 35, die im zweiten Schuss B aufgenommen wurden. Das bedeutet, es ist eine zeitliche Korrelation vorhanden. Um diese auch für die später angewendete trainierte Klassifizierungsfunktion erkennbar zu machen, werden bei der Zusammenstellung des Eingangsdatensatzes diese k-Raumabschnitte 34, konkret die k-Raumzeilen 35 gemäß dem Pfeil 36 neu sortiert beziehungsweise konkateniert, und zwar entlang einer neuen Dimension "Schuss". Es ist nun klar ersichtlich, dass die k-Raumpunkte 33a allesamt in den mittleren, dem Schuss B zugeordneten Satz von k-Raumlinien 35 zu finden sind. Diese neue Dimension der Schüsse A, B, C wird in Fig. 4 mit dem Pfeil 37 gekennzeichnet.

Aus den Vorgangsdaten werden im Schritt S3, zurückkehrend zu Fig. 3, auch Zusatzinformationen ausgewählt, die dem Eingangsdatensatz hinzuzufügen sind. Diese Zusatzinformationen umfassen vorliegend zur Bildgebung verwendete Spulen beschreibende Spuleninformationen, die Orientierung vermessener Volumina, hiervon Schichten, beschreibende Orientierungsinformationen und Gradienteninformationen, die während des Bildgebungsvorgangs ausgespielte Gradientenpulse beschreiben. Insbesondere ergibt sich aus der Gradienteninformation eine Hauptaktivitätsrichtung der Gradienten. Ferner kann die Zusatzinformation auch einen Temperaturmesswert wenigstens eines Temperatursensors der Magnetresonanzeinrichtung und ein den Schließzustand einer Tür der Schirmkabine anzeigendes Türsensorsignal umfassen.

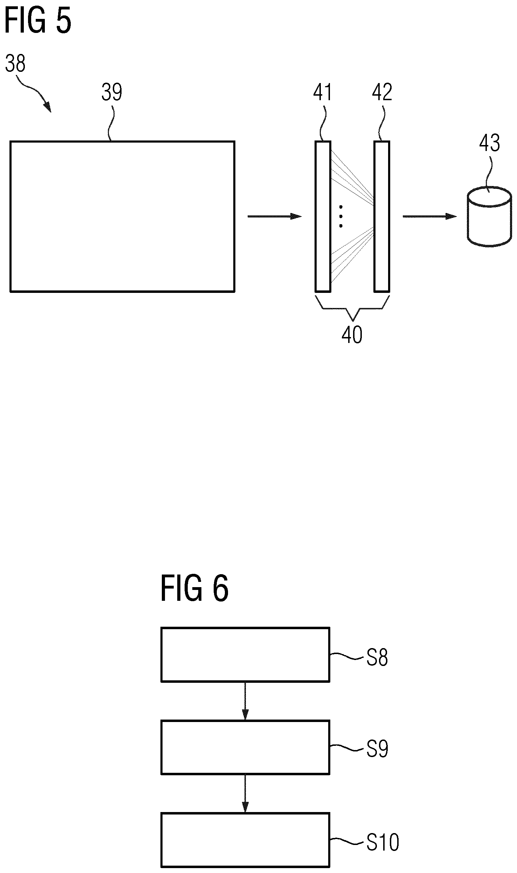

Nach dem Zusammenstellen des Eingangsdatensatzes wird in einem Schritt S4 der trainierte Klassifizierungsalgorithmus auf die Eingangsdaten des Eingangsdatensatzes angewendet. Der trainierte Klassifizierungsalgorithmus umfasst ein Convolutional Neural Network 22, vorliegend beispielhaft ein ResNet-18, dessen allgemeine Struktur in Fig. 5 näher erläutert ist. Dementsprechend umfasst die trainierte Klassifizierungsfunktion 38 eine Faltungsbasis 39, die, wie grundsätzlich bekannt, hauptsächlich aus Faltungsschichten 24 und Pooling-Schichten 25 aufgebaut ist. Zwischen verschiedenen Faltungsblöcken können dabei "Skip Connections" vorliegen. An die Faltungsbasis 39 schließt sich ein Klassifikator 40 an, der vorliegend beispielhaft eine erste vollständig verbundene Schicht 41 mit 512 Knoten und eine zweite vollständig verbundene Schicht 42 mit einer Zahl von Knoten aufweist, die der Zahl der durch die Klassifizierungsfunktion 38 unterscheidbaren Ursachen für Spike-Fehlwerte, gegebenenfalls um eins erhöht, entspricht. Die Erhöhung von eins ist dann sinnvoll, wenn die trainierte Klassifizierungsfunktion 38 auch zur Detektion des Vorliegens von Fehlwerten ausgebildet ist, so dass der zusätzliche Knoten beziehungsweise Eintrag des den Ausgangsdatensatz 43 bildenden Vektors von Wahrscheinlichkeitswerten anzeigen kann, dass keine Störung gefunden wurde. Die, gegebenenfalls weiteren, Einträge, also Wahrscheinlichkeitswerte, in dem Ausgangsdatensatz 43 betreffen dann die Wahrscheinlichkeiten für das Vorliegen verschiedener Ursachen für die Fehlwerte in den Bilddaten, beispielsweise "wackelndes Gradientenkabel", "Überspannung in Gradientenspule", "Hochfrequenz-Störer außerhalb der Schirmkabine", "Hochfrequenz-Störer innerhalb der Schirmkabine", "metallisches Objekt in der Patientenaufnahme", usw. Der Ausgangsdatensatz 43 kann auch, insbesondere Einträgen zugeordnet, weitere Informationen enthalten, insbesondere Lokalisierungsinformationen, die den Ort der Ursache beschreiben, bei Defekten/wackligen Kabeln beispielsweise das entsprechende, konkrete Kabel. Diese Lokalisierungen können auch über eigene Einträge des Vektors beschrieben sein. Eine Lokalisierungsinformation kann die Klassifizierungsfunktion 38 beispielsweise unter Nutzung der Zusatzinformationen ermitteln. Die entsprechenden Ergebnisse können dann beispielsweise in weiteren Einträgen der vollständig verbundenen Schicht 42 gespeichert sein.

In einem Schritt S5 werden weiterzugebende Ausgangsdaten des Ausgangsdatensatzes ausgewählt. Beispielsweise kann hier ein Eindeutigkeitskriterium ausgewertet werden, welches entscheidet, ob eine einzig klare Ursache (beziehungsweise gegebenenfalls die Aussage "keine Störung") weiterzugeben ist, mithin das Ergebnis hinreichend eindeutig ist, oder ob mehrere potentielle Ursachen, insbesondere mit zugeordneten Wahrscheinlichkeiten, weiterzugeben sind. Hierbei kann das Eindeutigkeitskriterium beispielsweise Schwellwertvergleiche vornehmen, wobei beispielsweise Schwellwerte vorgegeben werden können, die die Wahrscheinlichkeit zur Weitergabe überschreiten muss (beispielsweise 25 oder 30 Prozent) und/oder hinsichtlich der Eindeutigkeit überprüft wird, ob ein Wahrscheinlichkeitswert größer als 50 Prozent und/oder um einen bestimmten Prozentsatz höher als der nächst niedrige Wahrscheinlichkeitswert ist.

In einem Schritt S6 werden die weitergegebenen Ausgangsdaten des Ausgangsdatensatzes 43 zur Ermittlung wenigstens einer Maßnahme ausgewertet. Mögliche Maßnahmen umfassen dabei vorliegend das Vornehmen eines Eintrags in einen Fehlerspeicher, das Ausgeben eines Hinweises an einen Benutzer, der die ausgegebenen Ausgangsdaten enthält, beziehungsweise auf diese bezogen ist, das Senden einer Meldung an einen Wartungsdienst, der entsprechend die ausgegebenen Ausgangsdaten enthalten oder auf diese bezogen sein kann, und die Auswahl und Anwendung eines, gegebenenfalls die Ausgangsdaten nutzenden, Korrekturalgorithmus für die Bilddaten. Eine Meldung an einen Wartungsdienst kann beispielsweise Hinweise darauf enthalten, welche Komponenten der Magnetresonanzeinrichtung zu überprüfen sind. Die Ausgabe eines Hinweises an das Bedienpersonal kann beispielsweise der Art "Störsignale festgestellt. Bitte überprüfen Sie, ob sich Netzteile oder defekte Leuchtstoffröhren in der Schirmkabine befinden." lauten und optisch und/oder akustisch ausgegeben werden. Der Korrekturalgorithmus kann als Fehlwertkorrekturmaßnahme verstanden werden und konkret beispielsweise eine Bildkorrekturfunktion sein, insbesondere eine solche, die ein neuronales Netz zur Beseitigung zufälliger Störungen heranzieht oder konkrete Korrekturmaßnahmen durchführt, beispielsweise das Entfernen oder Ersetzen bestimmter Datenpunkte in k-Raumlinien 35.

Die entsprechenden, ermittelten Maßnahmen werden im Schritt S7 ausgeführt, wonach zu Schritt S1 zurückgekehrt werden kann.

Fig. 6 zeigt Schritte zur Bereitstellung der trainierten Klassifizierungsfunktion 38. Dabei werden zunächst in einem Schritt S8 eine vortrainierte Klassifizierungsfunktion sowie Trainingsdatensätze bereitgestellt, die jeweils einen Eingangsdatensatz und eine zugeordnete Grundwahrheit, insbesondere einen Ausgangsdatensatz 43, umfassen, mithin annotiert sind. Diese Basis von Trainingsdatensätzen wird in einem Schritt S9 noch erweitert, indem weitere Trainingsdatensätze unter Verwendung einer Charakteristika-Information aus fehlerfreien Eingangsdatensätzen synthetisiert werden. Die Gesamtmenge an Trainingsdatensätzen wird dann in einem Schritt S10 genutzt, um die vortrainierte Klassifizierungsinformation durch Transferlernen anzupassen und so die trainierte Klassifizierungsfunktion 38 zu erhalten. Dabei ist es insbesondere denkbar, dass in Ausführungsbeispielen wenigstens teilweise die Faltungsbasis 39 unverändert bleibt und lediglich der Klassifizierer 40 angepasst wird, mithin auf den bereits in der vortrainierten Klassifizierungsinformation ermittelbaren Merkmalen gearbeitet wird.

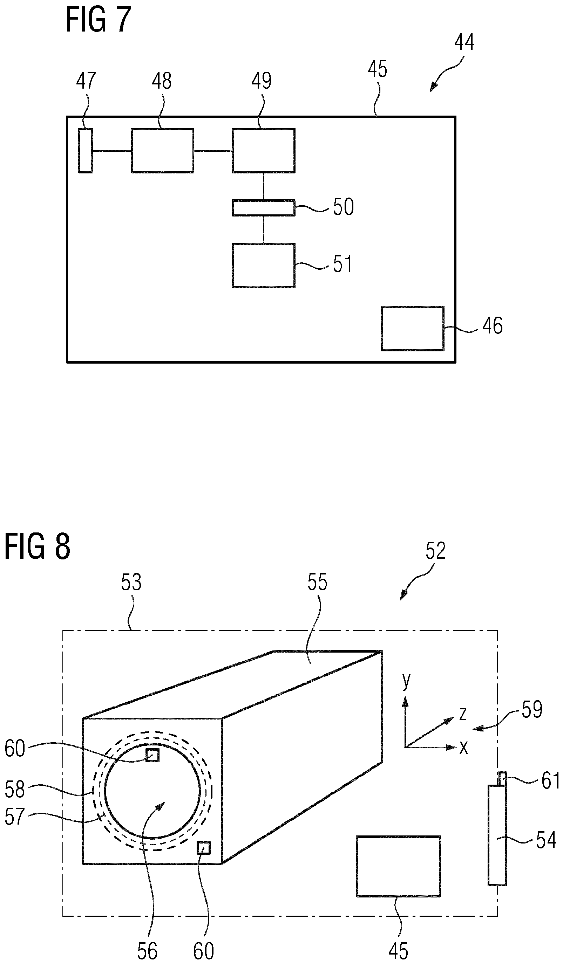

Fig. 7 zeigt die funktionale Struktur einer erfindungsgemäßen Recheneinrichtung 44, die vorliegend als Steuereinrichtung 45 einer Magnetresonanzeinrichtung ausgebildet ist. Neben einem Speichermittel 46, in dem neben verschiedenen Daten beispielsweise auch die trainierte Klassifizierungsfunktion 38 gespeichert sein kann, umfasst die Recheneinrichtung 44 ferner verschiedene Funktionseinheiten, um Schritte des erfindungsgemäßen Verfahrens durchzuführen, sowie, vorliegend interne, Schnittstellen. Über eine erste interne Schnittstelle 47 werden, beispielsweise von einer Sequenzeinheit, die den Aufnahmebetrieb steuert, Vorgangsdaten zu dem Bildgebungsvorgang erhalten. Die (hier nicht näher gezeigte) Sequenzeinheit kann beispielsweise den Bildgebungsvorgang im Schritt S1 steuern. In einer Zusammenstellungseinheit 48 wird der Eingangsdatensatz gemäß dem Schritt S3 zusammengestellt. In einer Klassifizierungseinheit 49 wird der Klassifizierungsalgorithmus gemäß dem Schritt S4 angewendet. In der Klassifizierungseinheit 49 kann dann auch bereits die Auswahl weiterzugebender Ausgangsdaten des Ausgangsdatensatzes 43 gemäß Schritt S5 erfolgen. Diese auszugebenden beziehungsweise weiterzugebenden Ausgangsdaten des Ausgangsdatensatzes 43 gelangen über eine zweite interne Schnittstelle 50 zu einer Maßnahmeneinheit 51 zur Durchführung der Schritte S6 und S7.

Fig. 8 zeigt schließlich eine Prinzipskizze einer Magnetresonanzeinrichtung 52, die vorliegend eine in einer Schirmkabine 53 mit einer Tür 54 angeordnete Hauptmagneteinheit 55 mit einem nicht näher gezeigten, das Hauptmagnetfeld der Magnetresonanzeinrichtung 52 erzeugenden Hauptmagneten aufweist. Die Hauptmagneteinheit 55 definiert eine zylindrische Patientenaufnahme 56, in die mittels einer hier nicht näher gezeigten Patientenliege ein Patient zur Durchführung eines Bildgebungsvorgangs eingefahren werden kann. Die Patientenaufnahme 56 umgebend können eine Hochfrequenzspulenanordnung 57 (Ganzkörperspulenanordnung) und eine Gradientenspulenanordnung 58 mit Gradientenspulen für die drei Hauptrichtungen der Magnetresonanzeinrichtung 52 angeordnet sein. Ein entsprechendes Koordinatensystem 59 ist angedeutet.

Der Betrieb der Magnetresonanzeinrichtung 52 wird mittels der Steuereinrichtung 45 gesteuert, welche teilweise auch außerhalb der Schirmkabine 53 angeordnet sein kann. Diese Steuereinrichtung 45 nimmt im Übrigen auch Sensordaten weiterer Hochfrequenzsensoren 60 entgegen, wie sie an zwei Stellen beispielhaft angedeutet sind, und Signale eines Türöffnungssensors 61, der der Tür 54 zugeordnet ist.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.


## Patentansprüche

1. Computerimplementiertes Verfahren zum Betrieb einer Magnetresonanzeinrichtung (52), wobei zur Ermittlung wenigstens einer potentiellen Ursache für einen Fehlwert, insbesondere einen Spike-Fehlwert, in den Bilddaten wenigstens eines Bildgebungsvorgangs

   - ein zu analysierender Eingangsdatensatz umfassend während dem Bildgebungsvorgang erfasste Hochfrequenzsignaldaten zusammengestellt wird,
   - auf den Eingangsdatensatz eine trainierte Klassifizierungsfunktion (38) der künstlichen Intelligenz zur Ermittlung eines Ausgangsdatensatzes (43), der potentielle Ursachen des Fehlwerts beschreibt, angewendet wird, und
   - wenigstens ein Teil der Ausgangsdaten des Ausgangsdatensatzes (43) ausgegeben wird.

2. Verfahren nach Anspruch 1, **dadurch gekennzeichnet, dass** die Hochfrequenzsignaldaten wenigstens einen Teil der Bilddaten des Bildgebungsvorgangs im k-Raum und/oder in einem Hybridraum und/oder im Bildraum umfassen.

3. Verfahren nach Anspruch 2, **dadurch gekennzeichnet, dass** bei der Aufnahme mehrerer k-Raumabschnitte (34) nach einem gemeinsamen Anregungspuls in einem Schuss (A, B, C) als zusätzliche Dimension der Hochfrequenzsignaldaten des Eingangsdatensatzes die k-Raumabschnitte (34), insbesondere zeitlich, zu dem jeweiligen Schuss (A, B, C) zugeordnet werden und/oder dass als weitere Dimension der Hochfrequenzsignaldaten des Eingangsdatensatzes eine Zuordnung zu einem Spulenkanal, in dem sie aufgenommen wurden, verwendet wird.

4. Verfahren nach einem der vorangehenden Ansprüche, **dadurch gekennzeichnet, dass** die Hochfrequenzsignaldaten von wenigstens einem weiteren, nicht zur Bildgebung genutzten Hochfrequenzsensor (60) der Magnetresonanzeinrichtung (52) aufgenommene Sensordaten umfassen.

5. Verfahren nach Anspruch 4, **dadurch gekennzeichnet, dass** der wenigstens eine weitere Hochfrequenzsensor (60) eine Pickup-Spule und/oder einen Atemsensor umfasst.

6. Verfahren nach einem der vorangehenden Ansprüche, **dadurch gekennzeichnet, dass** der Eingangsdatensatz neben den Hochfrequenzsignaldaten wenigstens eine Zusatzinformation über den Bildgebungsvorgang umfasst.

7. Verfahren nach Anspruch 6, **dadurch gekennzeichnet, dass** die Zusatzinformation gewählt ist aus der Gruppe umfassend

   - eine zur Bildgebung verwendete Spulen beschreibende Spuleninformation,
   - eine eine Orientierung vermessener Volumina, insbesondere von Schichten, beschreibende Orientierungsinformation und/oder eine während des Bildgebungsvorgangs ausgespielte Gradientenpulse beschreibende Gradienteninformation,
- wenigstens ein Temperaturmesswert eines Temperatursensors der Magnetresonanzeinrichtung (52), und
- ein den Schließzustand einer Tür (54) einer Schirmkabine (53) der Magnetresonanzeinrichtung (52) anzeigendes Türsensorsignal.

8. Verfahren nach Anspruch 7, **dadurch gekennzeichnet, dass** die trainierte Klassifizierungsfunktion (38) unter Verwendung der Zusatzinformation, insbesondere der Spuleninformation und/oder der Orientierungsinformation und/oder der Gradienteninformation, wenigstens zu einer Ursache eine Lokalisierungsinformation, die den Ort der Ursache beschreibt, als Teil des Ausgangsdatensatzes (43) ermittelt.

9. Verfahren nach einem der vorangehenden Ansprüche, **dadurch gekennzeichnet, dass** die trainierte Klassifizierungsfunktion (38) als neuronales Netzwerk (22) ein ResNet, insbesondere ein ResNet-18, und/oder ein AlexNet und/oder ein SqueezeNet umfasst.

10. Verfahren nach einem der vorangehenden Ansprüche, **dadurch gekennzeichnet, dass** auf Basis der ausgegebenen Ausgangsdaten wenigstens eine Maßnahme ermittelt und durchgeführt wird.

11. Verfahren nach Anspruch 10, **dadurch gekennzeichnet, dass** die wenigstens eine Maßnahme aus der Gruppe umfassend

- einen Fehlerspeichereintrag speichern,
- einen, insbesondere auf die ausgegebenen Ausgangsdaten bezogenen und/oder diese enthaltenden, Hinweis an einen Benutzer ausgeben,
- eine, insbesondere auf die ausgegebenen Ausgangsdaten bezogene und/oder diese enthaltende, Meldung an einen Wartungsdienst senden, und
- einen, insbesondere anhand der ausgegebenen Ausgangsdaten gewählten und/oder diese nutzenden, Korrekturalgorithmus auf die Bilddaten anwenden,

gewählt wird.

12. Verfahren nach einem der vorangehenden Ansprüche, **dadurch gekennzeichnet, dass** zur Bereitstellung der trainierten Klassifizierungsfunktion (38) eine vortrainierte Klassifizierungsfunktion bereitgestellt wird und mittels Transferlernen auf Grundlage von Trainingsdatensätzen trainiert wird, wobei jeder Trainingsdatensatz einen Eingangsdatensatz und eine zugeordnete Grundwahrheit umfasst.

13. Verfahren nach Anspruch 12, **dadurch gekennzeichnet, dass** wenigstens ein Teil der Eingangsdatensätze der Trainingsdatensätze aus fehlwertfreien Basisdatensätzen mittels einer Ursachen zugeordneten Charakteristikainformation ermittelt wird.

14. Computerprogramm, aufweist Programmmittel derart, dass beim Ausführen des Computerprogramms auf einer Recheneinrichtung (44) diese die Schritte eines Verfahrens nach einem der vorangehenden Ansprüche durchführt.

15. Elektronisch lesbarer Datenträger, auf dem ein Computerprogramm nach Anspruch 14 gespeichert ist.

16. Recheneinrichtung (44), welche zur Ermittlung wenigstens einer potentiellen Ursache für einen Fehlwert, insbesondere einen Spike-Fehlwert, in den Bilddaten wenigstens eines Bildgebungsvorgangs aufweist:

- eine erste Schnittstelle (47) zum Erhalt von den Bildgebungsvorgang beschreibenden Vorgangsdaten, welche zumindest während dem Bildgebungsvorgang erfasste Hochfrequenzsignaldaten umfassen,
- eine Zusammenstellungseinheit (48) zur Zusammenstellung eines zu analysierenden Eingangsdatensatzes, der zumindest einen Teil der Hochfrequenzsignaldaten enthält, aus den Vorgangsdaten,
- eine Klassifizierungseinheit (49) zum Anwenden einer trainierten Klassifizierungsfunktion (38) der künstlichen Intelligenz auf den Eingangsdatensatz zur Ermittlung eines Ausgangsdatensatzes (43), der potentielle Ursachen des Fehlwerts beschreibt,
- eine zweite Schnittstelle (50) zur Ausgabe wenigstens eines Teils der Ausgangsdaten des Ausgangsdatensatzes (43).

FIG 1

FIG 2

# FIG 3

# FIG 4

## FIG 5

## FIG 6

## FIG 7

## FIG 8

Europäisches
Patentamt

European
Patent Office

Office européen
des brevets

# EUROPÄISCHER RECHERCHENBERICHT

**Nummer der Anmeldung**

**EP 23 15 8173**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 486 675 A1 (SIEMENS HEALTHCARE GMBH [DE]) 22. Mai 2019 (2019-05-22)<br>* Abbildungen 1,2,3,4,5 *<br>* Absatz [0001] – Absatz [0065] *<br>----- | 1-16 | INV.<br>G01R33/56<br>G06N3/02 |
| X | US 2020/089983 A1 (MANICKAM KAVITHA [IN] ET AL) 19. März 2020 (2020-03-19)<br>* Abbildungen 1,2,3,4,5,6,7,8 *<br>* Absatz [0016] – Absatz [0060] *<br>----- | 1-16 | |
| A | US 2016/327606 A1 (VAN WIERINGEN ARJAN TEODOR [NL])<br>10. November 2016 (2016-11-10)<br>* Absatz [0018] – Absatz [0033] *<br>----- | 1-16 | |

**RECHERCHIERTE SACHGEBIETE (IPC)**

G01R
G06N

Der vorliegende Recherchenbericht wurde für alle Patentansprüche erstellt

| Recherchenort | Abschlußdatum der Recherche | Prüfer |
|---|---|---|
| München | 10. Juli 2023 | Durst, Markus |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.......................................................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 15 8173

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-07-2023

| Im Recherchenbericht angeführtes Patentdokument | Datum der Veröffentlichung | Mitglied(er) der Patentfamilie | Datum der Veröffentlichung |
|---|---|---|---|
| EP 3486675 A1 | 22-05-2019 | CN 109805932 A | 28-05-2019 |
| | | EP 3486675 A1 | 22-05-2019 |
| | | KR 20190058328 A | 29-05-2019 |
| | | US 2019155709 A1 | 23-05-2019 |
| US 2020089983 A1 | 19-03-2020 | CN 110910990 A | 24-03-2020 |
| | | US 2020089983 A1 | 19-03-2020 |
| US 2016327606 A1 | 10-11-2016 | CN 105874345 A | 17-08-2016 |
| | | EP 3090274 A1 | 09-11-2016 |
| | | JP 6427582 B2 | 21-11-2018 |
| | | JP 2017506926 A | 16-03-2017 |
| | | US 2016327606 A1 | 10-11-2016 |
| | | WO 2015101556 A1 | 09-07-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- DE 102018216362 B3

- US 10705170 B1

**In der Beschreibung aufgeführte Nicht-Patentliteratur**

- **K. HE et al.** Deep residual learning for image recognition. *arXiv:1512.03385,* 2015